# EUROPEAN PATENT APPLICATION

(11) **EP 2 685 515 A1**
(43) Date of publication of application: **15.01.2014**
(21) Application number: 12176108.4
(22) Date of filing: 12.07.2012
(51) Int. Cl.: H01L 51/52, H01L 51/56

(54) **Method and system for dividing a barrier foil**

(71) Applicant: Nederlandse Organisatie voor Toegepast -Natuurwetenschappelijk Onderzoek TNO, 2628 VK Delft (NL)
(72) Inventor: Unnikrishnan, Sandeep, 2628 VK Delft (NL); van Mol, Antonius Maria Bernardus, 2628 VK Delft (NL)
(74) Representative: Jansen, Cornelis Marinus

(57) **Abstract**

A method and system are provided for dividing a continuous barrier foil into a barrier foil segment that may be cut without exposing an organic layer in the barrier foil segment. A groove is formed alongside a perimeter of the barrier foil segment. The groove extends through the organic layer and is sealed by a sealing material to form a sealed groove. The sealed groove may prevent moisture and/or oxygen from reaching organic material in the barrier foil segment when it is cut. A sealed barrier foil segment is thus provided.

## Description

### FIELD AND BACKGROUND OF THE INVENTION

The present invention relates to a method and system for dividing a foil segment from a continuous barrier foil. The invention further relates to the foil segment as such.

Barrier foils find application in the production of device stacks for protecting sensitive components or materials from environmental influences. In one example, an organic layer is sandwiched between barrier foils to prevent moisture and/or oxygen from seeping into the organic layer. The organic layer may e.g. be part of an organic light emitting device (OLED), organic photovoltaic device (OPV), or other moisture and/or oxygen sensitive component.

Large batches of device stacks may conveniently be produced in a roll-to-roll (R2R) or roll-to-sheet (R2S) process. Such a process typically involves providing a continuous substrate known as a 'web' and passing this substrate through various production processes, e.g. involving deposition of various material layers on the substrate. In one example, a substrate may form a continuous barrier foil comprising a continuous layered structure with an organic layer sandwiched between barrier foils.

To transform a continuous barrier foil into usable device components, there is a need for dividing the continuous barrier foil into segments. However, simply cutting the continuous barrier foil may result in exposure of the organic layer at edges of the segment where the foil is cut.

US 7,033,850 B2 discloses a method for making organic light-emitting diodes on a flexible substrate. The method includes supplying a flexible substrate, forming a plurality of thin-film layers on the flexible substrate to produce an organic light-emitting diode, disposing the flexible substrate above a barrier base and disposing a barrier cover over the substrate and the barrier base. A laser seals the barrier base to the barrier cover through the coated substrate. The coated substrate is cut in the process of forming the seal. The package, now including the barrier cover, barrier base, and coated substrate, continues to advance until it is cut through the barrier cover and barrier base. Unfortunately, this method may not be satisfactory in all cases, e.g. with brittle inorganic layers or crosslinked non-reflowing organic layers in the stack.

There is a need for an improved method and system for dividing a barrier foil segment from a continuous barrier foil. There is a further need for an improved barrier foil segment.

### SUMMARY OF THE INVENTION

In a first aspect there is provided a method according to claim 1. In particular there is provided a method for dividing a barrier foil segment from a continuous barrier foil. The barrier foil segment is to be cut from the continuous barrier foil along a pre-defined segment perimeter through the continuous barrier foil. The continuous barrier foil comprises a continuous layered structure comprising an organic layer sandwiched between barrier layers. The method comprises providing the continuous barrier foil and partially cutting through the continuous barrier foil forming an elongated groove into the continuous barrier foil alongside the segment perimeter. The elongated groove extends from one face of the continuous barrier foil all the way through at least the organic layer. The method further comprises depositing a sealing material into the elongated groove thus forming a sealed groove alongside the segment perimeter. The barrier layers and the sealed groove are arranged for enclosing organic material in at least part of the organic layer. The barrier layers and the sealed groove are furthermore adapted for preventing, in use, external moisture and/or oxygen from reaching the organic material through the sealed groove.

In this way a barrier foil is provided that can be cut along the segment perimeter alongside the sealed groove without exposing organic material in at least part of the organic layer. Digging a groove that does not fully sever the foil allows maintaining the advantages of continuous foil processing. This may improve production throughput, e.g. in R2R processing. The groove acts as a convenient receptacle for a subsequent sealing process, e.g. a liquid or powder precursor containing sealing material may be deposited into the groove and subsequently cured. This may improve possibilities for using various desired sealing materials. By variation of the groove dimensions, the amount of sealing material between the organic layer to be protected and the external environment may be varied. This may improve tuning the sealing capacity. The groove may be dug as deep as necessary, making this method applicable also for thicker foils wherein other processes such as fusing the barriers together may not be possible. This may improve the capability of sealing a wide variety of barrier foils.

In a second aspect there is provided a system according to claim 9. In particular there is provided a system arranged for dividing a barrier foil segment from a continuous barrier foil. The system comprises a foil providing means, a groove forming means, a groove sealing means, and a controller. The controller is arranged for controlling the foil providing means for providing the continuous barrier foil, wherein the continuous barrier foil comprises a continuous layered structure comprising an organic layer sandwiched between barrier layers. The controller is further arranged for controlling the groove forming means for partially cutting through the continuous barrier foil forming an elongated groove into the continuous barrier foil. The elongated groove extends alongside a predefined segment perimeter on the continuous barrier foil. The elongated groove furthermore extends from one face of the continuous barrier foil all the way through at least the organic layer. The controller is further arranged for controlling the groove sealing means for depositing a sealing material into the elongated groove. A sealed groove is thus formed alongside the segment perimeter. The sealed groove and the barrier layers are arranged for enclosing organic material in at least part of the organic layer and adapted for preventing, in use, external moisture and/or oxygen from reaching the organic material when the barrier foil segment is cut from the continuous barrier foil along the pre-defined segment perimeter through the continuous barrier foil.

This system may produce barrier foils that can be cut along the segment perimeter alongside the sealed groove without exposing organic material in at least part of the organic layer. Advantages of the method according to the first aspect may similarly apply to the system according to the second aspect.

In a third aspect there is provided a barrier foil segment according to claim 12. In particular there is provided a barrier foil segment comprising a layered structure comprising an organic layer sandwiched between barrier layers. The barrier foil segment comprises a sealed groove alongside a perimeter of the barrier foil segment. The sealed groove is formed by an elongated groove extending partially through the barrier foil segment from a face of the barrier foil segment all the way through at least the organic layer. The elongated groove is filled with a sealing material. The sealed groove and the barrier layers are arranged for enclosing organic material in at least part of the organic layer. The sealed groove and the barrier layers are adapted for preventing, in use, external moisture and/or oxygen from reaching the organic material.

This barrier foil segment according to the third aspect may be conveniently produced by the method according to the first aspect or the system according to the second aspect. Advantages may include that the barrier foil segment may be more durable and/or cheaper to produce than other known barrier foils.

### BRIEF DESCRIPTION OF THE DRAWINGS

These and other features, aspects, and advantages of the apparatus, systems and methods of the present invention will become better understood from the following description, appended claims, and accompanying drawing wherein:
FIG 1 shows an embodiment of a method for dividing a foil segment from a continuous barrier foil.
FIG 2 shows steps of another embodiment for dividing a foil segment from a continuous barrier foil.
FIG 3 shows a cross-section of a foil segment dividing from a continuous barrier foil as a step of yet another embodiment of a method for separating a foil segment from a continuous barrier foil.
FIG 4 shows a system arranged for separating a foil segment from a continuous barrier foil.
FIG 5 shows a perspective view of an embodiment of a segment perimeter.
FIG 6 shows a perspective view of another embodiment of a segment perimeter.
FIG 7 shows steps of an embodiment for dividing a foil segment from a continuous barrier foil using a laser.
FIG 8 shows an embodiment for filling a groove.
FIG 9 shows another embodiment for filling a groove.
FIG 10 shows another embodiment for filling a groove.
FIG 11 shows an embodiment of a sealed groove.
FIG 12 shows another embodiment of a sealed groove.
FIG 13 shows an OLED or OPV device stack comprising a foil segment.

### DETAILED DESCRIPTION

Unless otherwise defined, all terms (including technical and scientific terms) used herein have the same meaning as commonly understood by one of ordinary skill in the art to which this invention belongs as read in the context of the description and drawings. It will be further understood that terms, such as those defined in commonly used dictionaries, should be interpreted as having a meaning that is consistent with their meaning in the context of the relevant art and will not be interpreted in an idealized or overly formal sense unless expressly so defined herein. In some instances, detailed descriptions of well-known devices and methods may be omitted so as not to obscure the description of the present systems and methods. Terminology used for describing particular embodiments is not intended to be limiting of the invention. As used herein, the singular forms "a", "an" and "the" are intended to include the plural forms as well, unless the context clearly indicates otherwise. It will be further understood that the terms "comprises" and/or "comprising" specify the presence of stated features but do not preclude the presence or addition of one or more other features. All publications, patent applications, patents, and other references mentioned herein are incorporated by reference in their entirety. In case of conflict, the present specification, including definitions, will control.

The term "foil" refers to a sheet comprising one or more layers of material. Preferably, the foil is flexible such that it can be used in a roll-to-roll (R2R) or roll to sheet (R2S) manufacturing process. For such purpose, a foil may be considered flexible if it can be rolled or bent over a radius of curvature of 50 cm or less without losing its essential functionality, e.g. barrier and/or electronic functionality. Alternatively, or in conjunction a foil may be considered flexible if it has a flexural rigidity smaller than 500 Pa·m³_{.}

The term "barrier foil" refers to a foil that functions as a barrier against environmental influences such as moisture and/or oxygen. The barrier foil may be used to enclose sensitive materials or components thereby separating them from said environmental influences. The barrier foil may comprise one or more barrier layers having a low transmission rate for said environmental influences. The barrier layers are typically formed by inorganic material. A transmission rate of a barrier layer may be considered low if it significantly delays deterioration of the underlying layer as a result of the influence of external moisture and/or oxygen. For present applications an intrinsic water vapor transmission rate (WVTR) under standard atmospheric conditions below 10⁻⁵ grams of water per day per square meter of the barrier may be considered low. Alternatively or in addition, for present applications an oxygen transmission rate below one milliliter (ml) of oxygen per day per square meter of the barrier may be considered low.

The term "in use", e.g. with reference to the use of the barrier foil or barrier layer, intends to imply normal or average conditions wherein a user, e.g. end-user, would use the foil or a device comprising the foil. In such a situation the foil may be subjected to normal (average) ambient or atmospheric conditions such as humidity, oxygen-level, pressure, temperature, etc. A barrier layer arranged for preventing, in use, moisture and/or oxygen from reaching the organic layer is thus suitable to prevent or substantially delay external ambient moisture and/or oxygen from reaching the organic layer, which may otherwise damage the organic layer. In this way the life-time of the organic layer and/or the device may be extended during normal use, e.g. by a factor of 2 or more, preferably by a factor of 10 or more. Of course, the sealing properties of the barrier layer may comply to more stringent conditions, e.g. being also suitable for more extreme conditions such as using the device or foil under water. Also it is noted that e.g. the temperature of the foil may depend on its use, e.g. the device comprising the foil may heat the foil which may have an adverse effect on the barrier properties of the foil.

In a typical production process, the barrier layers may be separated by one or more planarization layers that may provide a planarized surface for depositing a barrier layer thereon. The planarization layer may comprise organic material. In one example an organic coating for planarization (OCP) is sandwiched between two barrier layers to form a single-dyad barrier foil. Organic material in the barrier foil itself is preferably also protected from said environmental influences. Alternatively or in addition, the organic material may itself function as part of the barrier, e.g. comprising moisture getters. When cutting a barrier foil into smaller barrier foil segments, it may be preferable to seal the cut edges of the segments before exposing these to the environmental influences.

The term "continuous" as in "continuous foil" refers to the fact that the foil comprises one or more continuous or non-segmented layers. The continuous layers may possess a high degree of translation symmetry along one or more of the dimensions of the foil. A continuous foil may also comprise a combination of continuous and non-continuous layers. When cutting a continuous foil, one or more of the continuous layers may get exposed at the cut edges. In some cases it is preferred to prevent this exposure by sealing the edges, e.g. in the case of cutting a continuous barrier foil. Before cutting, the continuous foil may be divided into foil segments.

The term "divide" as in "dividing a foil" refers to segmentation of the continuous foil into foil segments. Dividing the foil comprises the step of preparing the foil to be cut but does not necessarily include the step of cutting itself. One or more continuous layers of the foil, in particular the organic layers may be divided into separable segments. A foil segment may be prepared for cutting by pre-sealing the edges alongside a pre-defined segment perimeter along which the foil segment is to be cut.

The term "foil segment" may refer to a part of a continuous foil that has been divided. The foil segment may be cut from the continuous foil or still be part of the continuous foil. In one example, a continuous foil may be divided into foil segments in a R2R process without fully cutting the foil segments from one another. This way the divided foil segments can be more easily stored back onto a roll. The roll with divided foil segments may be cut into separate foil segments in a subsequent R2S process. In another example, the continuous foil may be subsequently divided and cut in a single R2S process. In yet another example, a sheet of continuous foil (not necessarily on a roll) may be divided into foil segments which may optionally be cut from the sheet of continuous foil, e.g. in a sheet to sheet process (S2S).

A continuous layer may be formed e.g. in a continuous production process. A continuous foil may be particularly suitable to be produced in a R2R process or further processed in a R2R or R2S process. In one example, a substrate is supplied from a first roll and passed through a layer deposition process to form a continuous layer on the substrate before being rolled back up into a second roll (R2R).

A non-continuous layer may be formed e.g. in a production process involving discrete steps. In one example, a continuous foil is supplied from a roll and passed through a pattern deposition apparatus which applies discrete patterns, e.g. circuitry lanes, onto the continuous foil. In another example, discrete components may be placed on the continuous foil. Alternatively or in addition, the continuous foil may be cut into discrete sheets (R2S) wherein each sheet forms a device component.

A typical barrier layer may comprise Silicon Nitride ("SiN"), e.g. having a layer thickness between 50-200 nm. Also any other suitable material and layer thickness, known to the skilled artisan, may be used for forming a barrier layer with desired characteristics with respect of water vapor and/or oxygen transmission. A typical technique for depositing the barrier layer onto a substrate, e.g. a foil, may comprise using plasma enhanced chemical vapor deposition (PECVD). Also any other suitable technique known to the skilled artisan may be used for depositing a barrier layer. When using such a deposition technique it may be preferred to provide a smooth substrate so as to avoid irregularities in the deposited layer. A planarization layer may be provided on the substrate to provide a smooth surface. The planarization layer may comprise organic material, e.g. a UV curable acrylate. A planarization layer of an organic material is also referred to as an organic coating for planarization (OCP). In addition to providing a planarization layer between the barrier layers, additional planarization layers may be provided, e.g. between a substrate and a barrier layer. OCP layer may typically have a layer thickness between 5-20 µm. Also other suitable planarization layers materials and/or layer thicknesses, known to the skilled artisan, may be used. It may be preferred to prevent moisture from seeping into the OCP layer, e.g. to prevent deformation and/or delaminating of barrier layers.

In one example, a single-dyad barrier foil comprises layers of SiN - OCP -SiN. The barrier foil pattern may be customized to suit the needs, e.g. of a custom sized OLED or display, which are processed on it. The production of barrier foils may be up scaled using R2R mass-production on an industrial scale. In such a scenario the barrier film is continuously processed on a substrate roll. During mass production of the barrier stack, unpatterned coating of the OCP may be more commercially viable than the customized printing or patterning of the OCP. Traditionally, the OCP layer is patterned to prevent side leakage. However, in a scenario wherein a company wants to produce barrier foils in a roll-to-roll fashion e.g. for supplying OEM customers, this company typically needs to know the device lay-out of their OEM customers beforehand, making this commercially a difficult business case. To make the production of OLEDs economical, a roll-to-roll continuous coating approach is preferred. In such an approach, all the layers of an OLED or OPV device are continuously deposited on a barrier foil and finally encapsulated. Optionally, the encapsulation can be done by laminating another barrier foil or a metal foil on the device. Apart from finding a suitable approach towards cutting, sealing the cut edge of the OLED, OPV or barrier stacks is also a challenge. An advantageous approach towards sealing and cutting of the aforementioned stacks is described herein.

The invention is described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. The description of the exemplary embodiments is intended to be read in connection with the accompanying drawings, which are to be considered part of the entire written description. In the drawings, the size and relative sizes of systems, components, layers, and regions may be exaggerated for clarity. Embodiments are described with reference to cross-section illustrations that are schematic illustrations of possibly idealized embodiments and intermediate structures of the invention.

In the description, relative terms as well as derivatives thereof should be construed to refer to the orientation as then described or as shown in the drawing under discussion. These relative terms are for convenience of description and do not require that the system be constructed or operated in a particular orientation unless stated otherwise. It will further be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. It will further be understood that when a particular step of a method is referred to as subsequent to another step, it can directly follow said other step or one or more intermediate steps may be carried out before carrying out the particular step. Like numbers refer to like elements throughout. As used herein, the term "and/or" includes any and all combinations of one or more of the associated listed items.

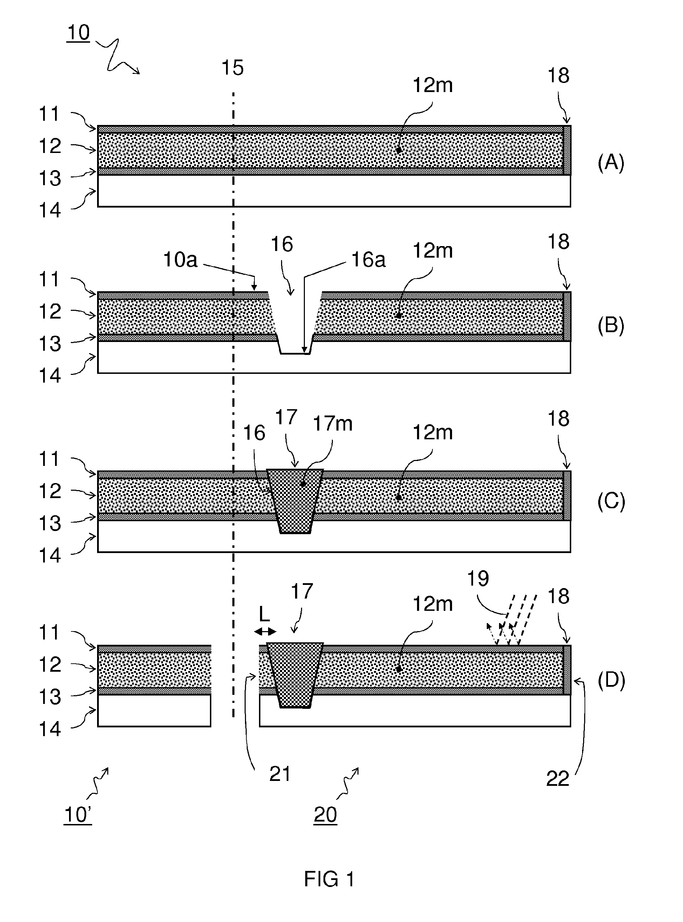

FIG 1 shows an embodiment of a method for dividing a barrier foil segment 20 from a continuous barrier foil 10. Cross-sectional views of the foils are schematically shown as steps (A) - (D).

Step (A) comprises providing a continuous barrier foil 10. The continuous barrier foil 10 comprises a continuous layered structure comprising an organic layer 12 sandwiched between barrier layers 11 and 13.

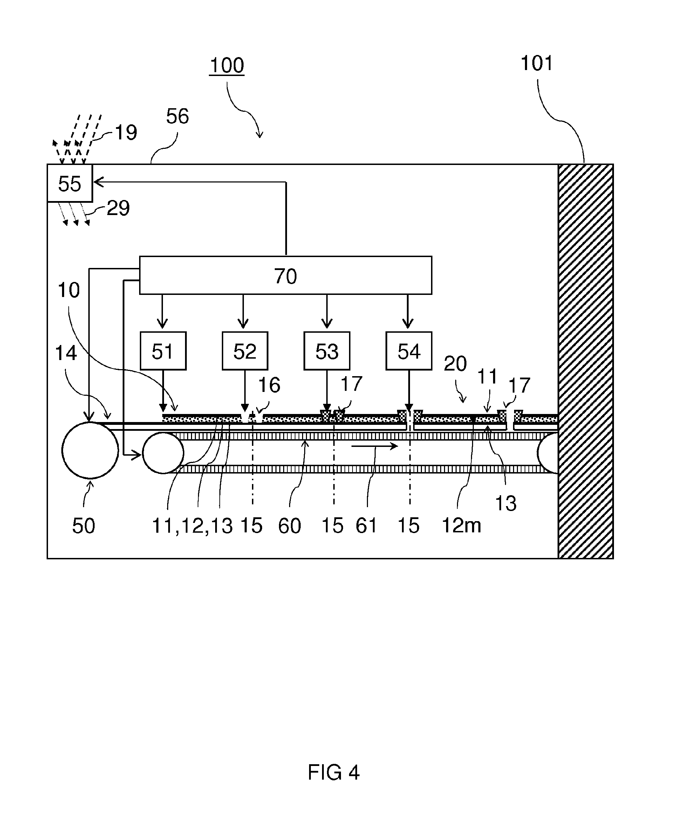

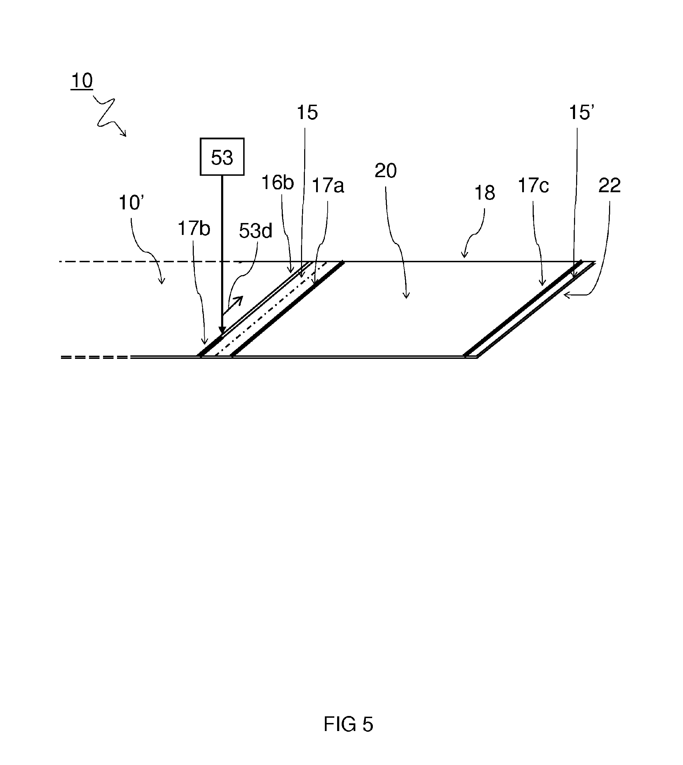

Step (B) comprises partially cutting through the continuous barrier foil 10 forming an elongated groove 16 into the continuous barrier foil 10. The elongated groove 16 extends alongside a predefined segment perimeter 15 on the continuous barrier foil 10. This may be more clearly visible in perspective view of FIG 4 and 5. In the cross-sectional view is shown that the elongated groove 16 extends from one face 10a of the continuous barrier foil 10 all the way through at least the organic layer 12.

Step (C) comprises depositing a sealing material 17m into the elongated groove 16. This forms a sealed groove 17 alongside the predefined segment perimeter 15. The sealed groove 17 and the barrier layers 11, 13 are arranged for enclosing organic material 12m in at least part of the organic layer 12. The sealed groove 17 and the barrier layers 11, 13 are adapted for preventing, in use, external moisture and/or oxygen 19 from reaching the organic material 12m in particular when the barrier foil segment 20 is cut from the continuous barrier foil 10 along the pre-defined segment perimeter 15 through the continuous barrier foil 10 as shown in step (D).

In an embodiment, the continuous barrier foil 10 divided by the sealed grooves 17 is cut along the segment perimeter 15 as shown in step (D). In this way a separate barrier foil segment 20 is obtained that is sealed from the external environment by the barrier layers 11, 13 and the sealed groove 17. In this case an end 22 of the barrier foil segment 20 may comprise a pre-sealed edge 18, e.g. provided in a previous sealing process. In an embodiment, the cutting through the continuous barrier foil 10 along the predefined segment perimeter 15 is performed during or before the sealed grooves 17 are applied. If cutting precedes sealing, it may be preferred to keep the time between these steps as short as possible to prevent environmental influences from degrading the exposed parts of the foil.

In another embodiment, the continuous barrier foil 10 divided by the sealed grooves 17 is kept in one piece, i.e. not cut up. The divided continuous barrier foil 10 may thus be used for further continuous processing or to be stored on roll.

The term "predefined" as used in "predefined segment perimeter" refers to the fact that the absolute or relative position of the segment perimeter is determined at the moment that the grooves are applied, e.g. the segment is already cut or an indication of where the segment is to be cut may be established e.g. relative to the sealed groove. The predefined segment perimeter may e.g. depend on the size and shape of a device that is to be manufactured with the segment perimeter. In a production system a segment perimeter may be predefined by a controller controlling the cutting and/or sealing process. Said controller may e.g. comprise a memory with instructions for cutting the foil in a certain shape and/or with a certain distance interval.

In an embodiment the predefined segment perimeter 15 is arranged at a distance L from the sealed groove 17, between the sealed groove 17 and a remnant 10' of the continuous barrier foil 10 from which the barrier foil segment 20 is to be cut. The distance L is preferably as small as possible so as not to waste material of the foil. On the other hand, the distance should be large enough so as not to damage the seal. By cutting the barrier foil at a distance from the sealed groove, damage to the sealed groove as a result of the cutting process may be prevented. Seepage of moisture or oxygen from the cut sides of the barrier foil segment into the organic layer of the barrier foil segment may be prevented by the sealed groove therein between. This may improve yield of the sealed foil segments. The distance L may depend on the foil cutting means, e.g. the spot size of a cutting laser or the thickness of a cutting blade. Typically, L may preferably be in the range of 10 - 500 µm.

In the shown embodiment, the continuous barrier foil 10 further comprises a substrate 14 for carrying the other layers. The substrate 14 may e.g. comprise a flexible foil. Typical materials used for a flexible substrate foil may include one or more of polyethylene terephthalate (PET), polyethylene naphtalate (PEN), polyetheretherketone (PEEK), and polycarbonate. The substrate 14 may have a typical thickness of 25-200 µm. Alternatively, to being flexible, the substrate 14 may also be non-flexible or rigid, e.g. a glass plate. Alternative to using a substrate, the layers 11, 12, and 13 may be self-supporting not requiring a substrate. In one example, the substrate 14 may be peeled off either before applying the presently disclosed method for dividing the continuous barrier foil or after.

In step (B) of the shown embodiment the groove 16 is dug through not only the organic layer 12 but also through the bottom barrier layer 13 and partly into the substrate 14. Alternatively, the groove bottom 16a stops short of the bottom barrier layer 13.

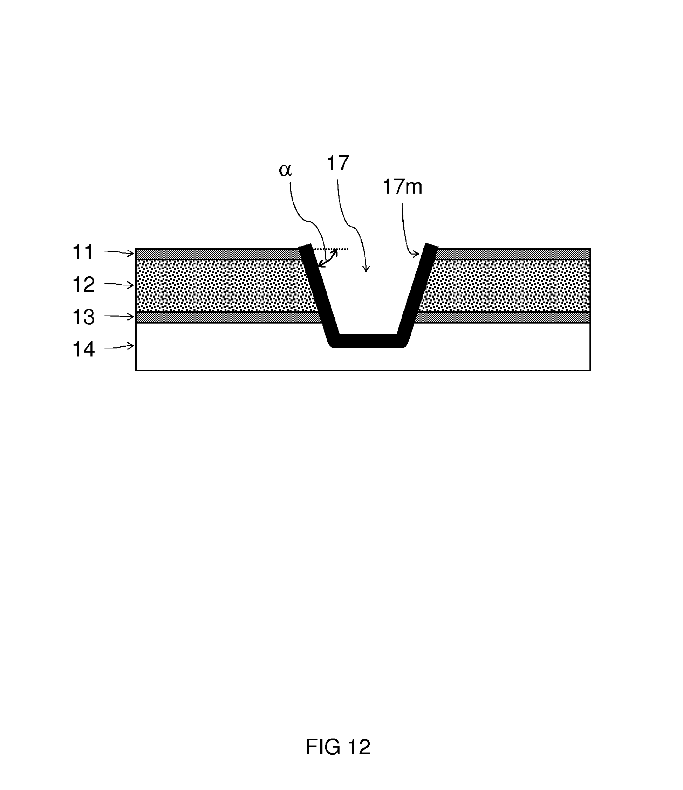

Whereas it is shown in this and other embodiments that the entire groove 16 is filled with sealing material 17m, alternatively the filling may be stopped when the sealing layer is thick enough to form sufficient protection against moisture and/or oxygen. An example of this is shown in FIG 12.

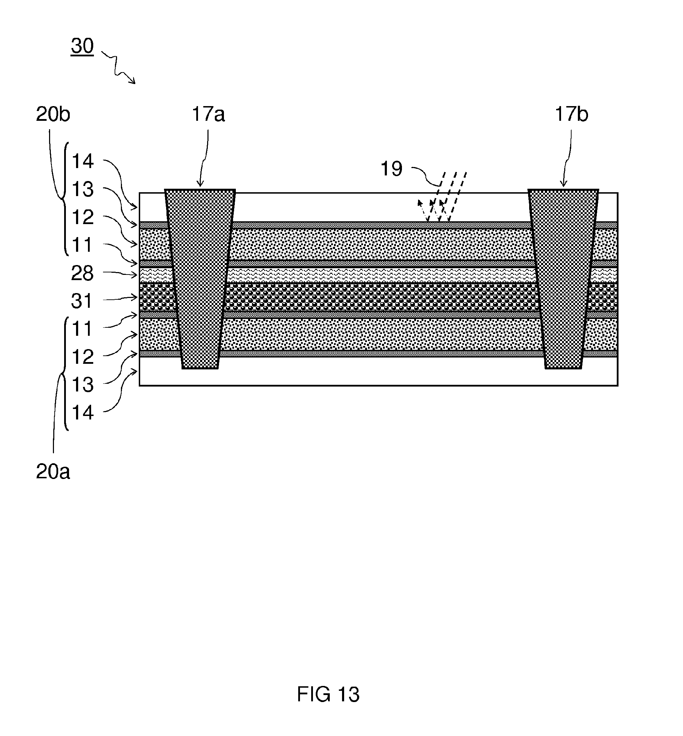

In addition, while the shown embodiment comprises a single dyad barrier formed by an organic layer 12 sandwiched between barrier layers 11 and 13, this configuration may be expanded with additional organic and barrier layers, forming what is referred to as a multi-dyad structure. For example on top of the barrier layer 11 there may be another organic layer and top of that another barrier layer. Thus a structure may be formed comprising the layers barrier-organic-barrier-organic-barrier. This structure may be further expanded. The more layers are provided, the better may be the barrier function. Accordingly, in a preferred there is provided a barrier foil comprising a layered structure comprising two or more organic layers sandwiched between barrier layers wherein the two or more organic layers are interposed by additional barrier layers. Also, other layers, e.g. electro-optical layers, may be interposed between the organic and/or barrier layers. When sealing a multi-layer barrier foil, preferably the sealed groove extends through the structure to cover all organic layers, e.g. as shown in FIG 13.

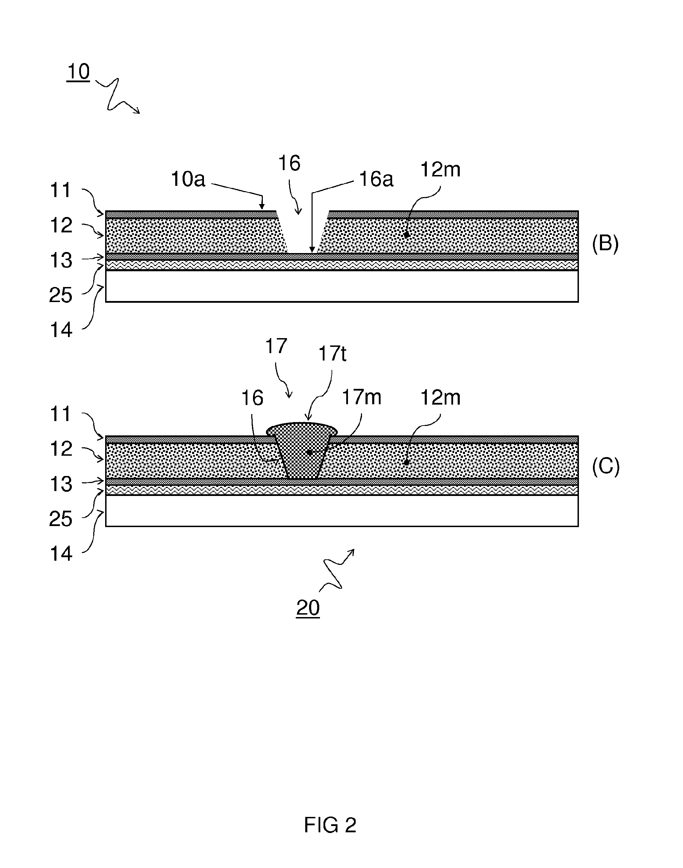

FIG 2 shows steps of another embodiment for dividing a foil segment 20 from a continuous barrier foil 10. The continuous barrier foil 10 comprises a continuous layered structure comprising a first barrier layer 11, an organic layer 12, a second barrier layer 13, a support layer 25, and a substrate 14.

In an embodiment as shown in step (B) of this figure, the partially cutting the continuous barrier foil comprises cutting through the organic layer 12 and stopping at the second barrier layer 13 between the organic layer 12 and the support layer 25 underneath. This may be achieved using e.g. controlled laser ablation or selective etching. Preferably, the cutting is controlled to prevent cracking of buckling of the inorganic layer, e.g. caused by excessive heat generation and dissipation in the layers. This may be controlled e.g. by tuning a wavelength and intensity (e.g. pulse width) of the laser. E.g. a higher pulse intensity or a higher absorption of the laser wavelength in the layers may favor ablation over heat dissipation. It is to be appreciated that the support layer 25 may additionally act as a planarization layer for providing a level support for the second barrier layer 13.

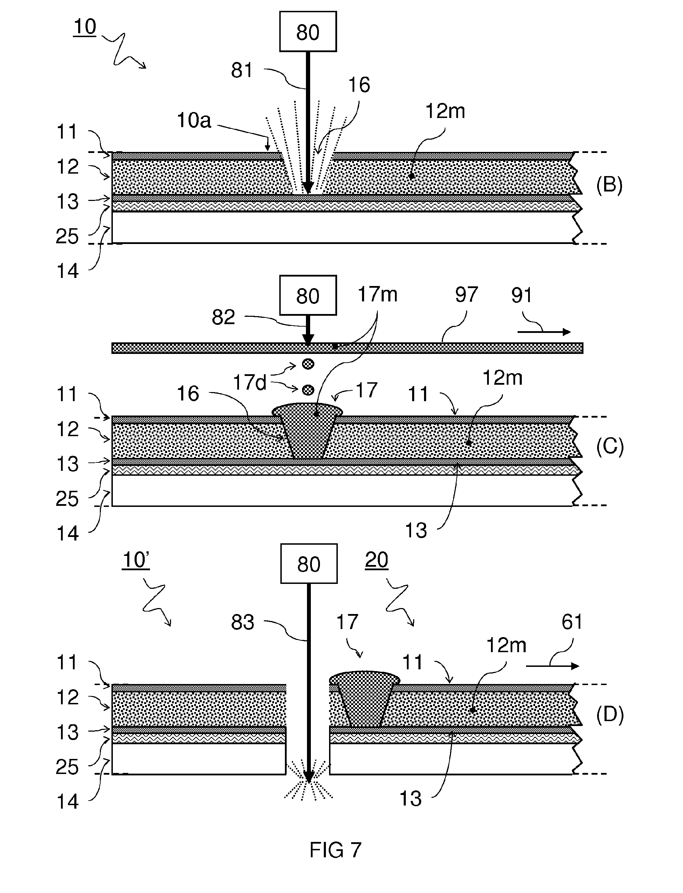

In an embodiment, the groove 16 is cut or dug using laser ablation. The wavelength and intensity of a laser can be adjusted to ablate almost any desired material. This may improve suitability of the method for a wide variety of barrier foils, e.g. not limited to barrier layers that can be fused. The method of cutting through the organic layer 12 and stopping at the second barrier layer 13 may be conveniently achieved by laser ablation as will be explained later with reference to FIG 7.

It is to be appreciated that the absorption spectrum of the barrier layers 11 and 13 may be adjusted not only by the choice of material but also depending on the parameters of the deposition process. For example, the refractive index of amorphous hydrogenated silicon nitride layers SiN:H deposited using PECVD can be changed depending on the parameters of the deposition process, e.g. the ratio or pressure of supplied precursor gases SiH4:NH3. Also the temperature during deposition may play a role. In this way an extinction coefficient at a certain wavelength, in particular at the laser wavelength, may be increased or decreased depending if it is desired that the layer be ablated or not. For example, in a deposition process, the first barrier layer 11 may be provided with a higher extinction coefficient at a certain wavelength and the second barrier layer 13 may be provided with a lower extinction coefficient. The absorption of the support layer may also be adjusted, e.g. by the choice of the material.

In an embodiment as shown in step (C) of this figure, the elongated groove 16 is overfilled with the sealing material 17m. As can be seen, this may result in a 'mushroom' shaped seal 17, wherein the top 17t of the seal 17 partly overhangs the top barrier layer 11. This configuration may have an advantage of providing a longer path length for moisture and/or oxygen to reach the enclosed organic material 12m, especially via the edges of the seal 17. This may be conveniently combined with the embodiment of step (B) of this figure wherein the bottom barrier layer 13 is kept intact. In this way moisture and/or oxygen may also be prevented from reaching the organic material 12m via the bottom substrate 14.

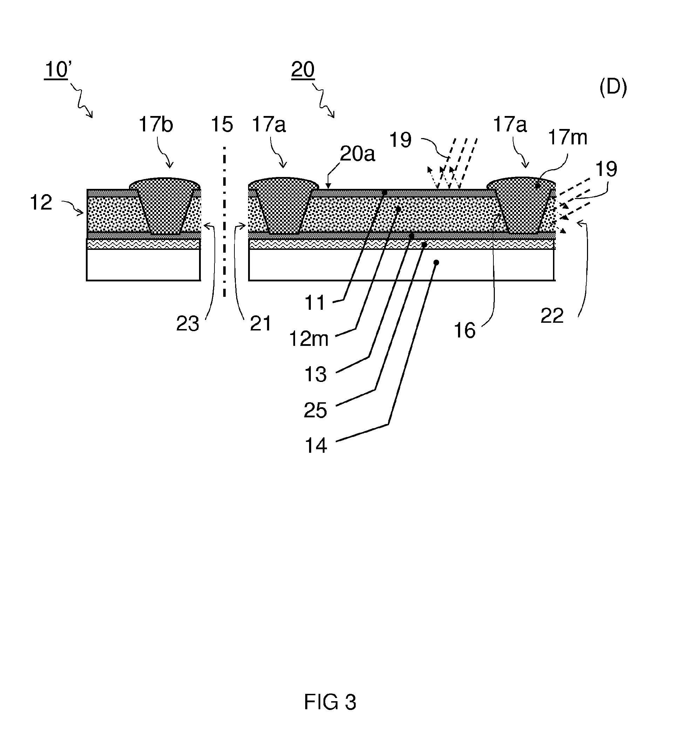

FIG 3 shows a cross-section of a foil segment 20 divided and cut from a continuous barrier foil 10 as an alternative for step (D) of the embodiments of FIG 1 or 2.

In the embodiment the sealed groove forms a first sealed groove 17a and the method further comprises providing a second sealed groove 17b alongside and distanced from the first sealed groove 17a. The segment perimeter 15 is arranged between the first and second sealed grooves 17a and 17b. In this way, both the barrier foil segment 20 and the remnant 10' of the continuous barrier foil from which the barrier foil segment 20 is cut may be protected from the external environmental influences 19. Advantageously, in a subsequent step another barrier foil segment may be cut from the remnant 10', wherein at least one side 23 of the said another barrier foil segment is already sealed. An advantage may be a minimal material wastage of the continuous barrier foil.

After cutting the continuous barrier foil alongside the segment perimeter 15, a separated barrier foil segment 20 is obtained. The barrier foil segment 20 comprises a layered structure comprising an organic layer 12 sandwiched between barrier layers 11 and 13. The barrier foil segment 20 comprises a sealed groove 17a along an outer perimeter 21, 22 of the barrier foil segment 20. The sealed groove 17a is formed by an elongated groove 16 extending partially through the barrier foil segment 20 from a face 20a of the barrier foil segment 20 all the way through at least the organic layer 12. The elongated groove 16 is filled with a sealing material 17m. The sealed groove 17a and the barrier layers 11 and 13 are arranged for enclosing organic material 12m in at least part of the organic layer 12. The sealed groove 17a and the barrier layers 11 and 13 are adapted for preventing, in use, external moisture and/or oxygen 19 from reaching the organic material 12m.

The sealed groove 17a may be one groove or comprise multiple grooves connecting sealed edges of the barrier foil segment. For example, some edges of the continuous barrier foil may have been pre-sealed, such as the pre-sealed edge 18 shown in FIG 1

FIG 4 shows a system 100 arranged for dividing and cutting a foil segment 20 from a continuous barrier foil 10. The system comprises a foil providing means 50, 60, a groove forming means 52, a groove sealing means 53, and a controller 70.

The controller 70 is arranged for controlling the foil providing means 50, 60 for providing the continuous barrier foil 10. The continuous barrier foil 10 comprises a continuous layered structure comprising an organic layer 12 sandwiched between barrier layers 11 and 13.

The controller 70 is further arranged for controlling the groove forming means 52 for partially cutting through the continuous barrier foil 10 forming an elongated groove 16 into the continuous barrier foil 10. The elongated groove 16 thus cut extends alongside a predefined segment perimeter 15 on the continuous barrier foil 10. The elongated groove 16 extends from one face of the continuous barrier foil 10 all the way through at least the organic layer 12. The controller may e.g. comprise a memory with instructions for determining an absolute or relative position of the predefined segment perimeter 15 and/or the elongated groove 16.

The controller 70 is further arranged for controlling the groove sealing means 53 for depositing a sealing material into the elongated groove 16 thus forming a sealed groove 17 alongside the segment perimeter 15. The sealed groove 17 and the barrier layers 11, 13 are arranged for enclosing organic material 12m in at least part of the organic layer 12 and adapted for preventing, in use, external moisture and/or oxygen from reaching the organic material 12m when the barrier foil segment 20 is cut from the continuous barrier foil 10 along the pre-defined segment perimeter 15 through the continuous barrier foil 10.

In the shown embodiment, the system 100 further comprises a foil cutting means 54. The controller 70 is further arranged for controlling the foil cutting means 54 for cutting through the continuous barrier foil 10 along the segment perimeter 15. Alternative to cutting the foil 10 after dividing it into segments, the foil 10 may also be kept intact e.g. for further processing or storing the divided continuous foil back on a roll.

In the shown embodiment, the system 100 further comprises layer deposition means 51, arranged for providing one or more layers onto a foil substrate 14. In the shown embodiment, the foil substrate 14 is supplied from a foil supply roll 50 and transported by a foil conveyor system 60, e.g. an endless conveyor belt moving the foil in direction 61. Also other known means for transporting a foil may be used, e.g. rollers. The layers deposited onto the substrate 14 may form the continuous barrier foil 10. The substrate 14 may be part of the continuous barrier foil 10 or may be removed after layer deposition. Alternative to the shown embodiment, the continuous barrier foil 10 may also be directly provided, e.g. from a supply roll comprising the continuous barrier foil 10. The continuous barrier foil 10 may e.g. be manufactured in a preceding R2R process.

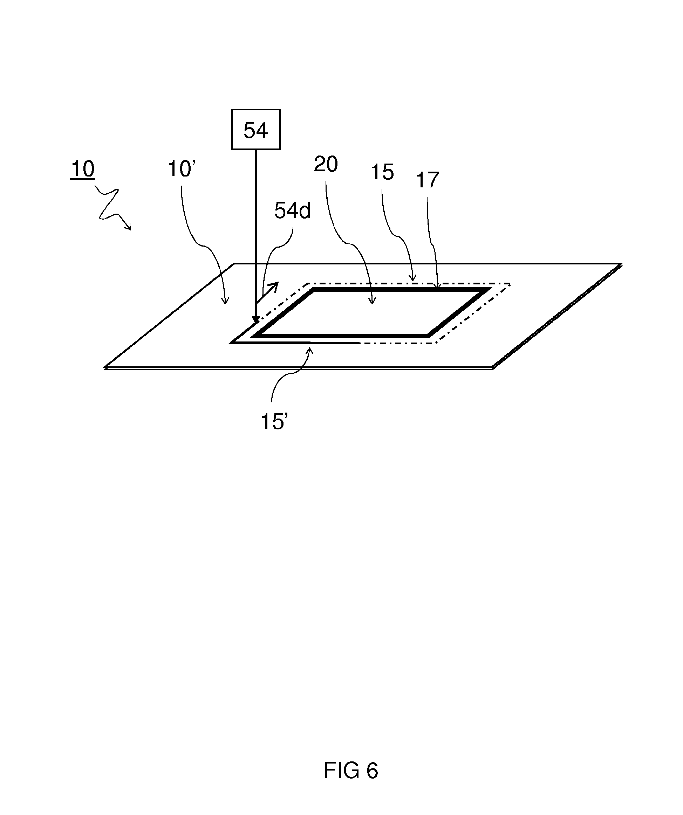

Alternative to providing the continuous barrier foil 10 from a roll, the continuous barrier foil 10 may also be provided as a sheet. E.g. a continuous barrier foil sheet may be divided into barrier foil segments by the system and process described herein. E.g. FIG 6 shows a foil segment 20 being divided and cut from a continuous barrier foil sheet 10. A foil providing means may thus include any and all means for providing a foil.

In the shown embodiment, the system 100 further comprises an enclosure 56. The continuous barrier foil is processed inside the enclosure. An environmental control system 55 may be used to provide a low-humidity and/or low oxygen environment inside the enclosure 56. While the continuous barrier foil 10 is cut it may be kept from external moisture and/or oxygen 19 by environmental control system 55 and/or the enclosure 56. For example, dry nitrogen may be flushed through the enclosure for providing an environment with low humidity and low oxygen. Alternatively or in addition, the enclosure may be kept at low pressure, e.g. vacuum. The partially cutting B the continuous barrier foil 10 may thus be preceded by bringing the foil into an environment having low moisture and/or low oxygen adapted to prevent deterioration of the organic material 12m when exposed to said environment.

In the shown embodiment, the foil is further processed in processing system 101. Further processing may include additional layer deposition. Further processing may take place on cut foil segments or on a non-cut foil. An advantage of cutting the foil segments may be to more easily handle them, e.g. when gluing separate foil segments. Keeping the divided foil segments together in a continuous foil facilitates further R2R processing.

In an embodiment (not shown), an OLED layer is deposited onto the divided barrier foil segments 20. The OLED layer may comprise additional layers such as, but not limited to light emitting layers, cathode and anode layers, and/or charge injection layers. The OLED layer may be covered by a second barrier foil layer. The second barrier foil layer may be deposited onto the OLED layer or glued to the OLED layer. The barrier foil segments may enclose the OLED layer. The barrier foil segments may be fused together or sealed in another way at the edges. In this way the OLED layer may be protected from moisture and/or oxygen. In another embodiment, the continuous barrier foil comprises an OLED layer as one of its organic layers. The OLED layer is thus sealed by sealing the continuous barrier foil. An example of this is shown in FIG 13.

FIG 5 shows a perspective view of an embodiment of a barrier foil segment 20 being divided from a continuous barrier foil 10. An elongated groove 16b extending alongside a predefined segment perimeter 15 on the continuous barrier foil 10 is being sealed by groove sealing means 53 resulting in sealed groove 17b alongside the predefined segment perimeter 15.

The shown embodiment may be suitable for dividing and cutting foil segments 20 from a continuous barrier foil 10, e.g. supplied from a roll according to FIG 3. The continuous barrier foil 10 may comprise pre-sealed edges 18, e.g. alongside a longitudinal dimension of the rolled out foil. Alternatively, edges 18 are sealed by a sealed groove or by another sealing process. It is thus understood that not all edges of the foil segment 20 are necessarily provided with sealed grooves. In particular, the sealed grooves may be provided at those parts of the foil segment perimeter 15 that are cut from the continuous barrier foil in the manner described herein.

In the shown embodiment the predefined segment perimeter 15 is arranged between sealed grooves 17a and 17b. The sealed groove 17b is arranged alongside to and distanced from the first sealed groove 17a. The sealed grooves 17a and 17b are arranged alongside the segment perimeter 15.

Although in embodiments, the sealed groove(s) may be arranged parallel to the segment perimeter this is not necessary. It is sufficient if the sealed groove(s) in cooperation with the first and the second inorganic layer enclose a part of the organic layer to prevent ingress of atmospherical substances such as moisture and oxygen therein. Accordingly, it is sufficient that the groove or sealed groove roughly follows the predefined segment perimeter at a distance thereof.

However, in order minimize material wastage when the foil is cut, it may be preferred that the groove perimeter is arranged close to the segment perimeter. With reference to FIG 5, the farther segment perimeter 15' is located from sealed groove 17c, the larger the strip alongside the edge 22 of the segment perimeter 20 that is not sealed from the external environment. In some cases, this strip may be considered as wasted material. In other cases it can be used for other purposes, e.g. for mounting the segment, or for application of components thereon that are not sensitive for moisture etc., e.g. electrical conductors to the main component. In one example, the groove and segment perimeter may have different shapes, e.g. the groove may be a straight line while the segment perimeter comprises a jagged pattern arranged roughly parallel to or alongside the groove. The jagged edges may be wasted material or may have a purpose e.g. in the further handling or processing of the foil segment. The non sealed strip at the edges of the foil segment may also provide a grip for holding the foil segment under a bezel of a display.

In some embodiments, cutting the foil too close to the sealed groove may lead to a risk of damaging the sealing. Therefore, the sealed groove may be arranged distanced from the segment perimeter 15. The term "distanced" may be understood as the groove or sealed groove being at a distance from the predefined segment perimeter such that when the foil is cut along said perimeter, the sealed groove is not damaged. A preferred distance may depend on the precision of the cutting means used. Alternative to cutting the foil at a distance from the sealed groove, the sealed groove may also be adapted to be cut through itself. For example, the sealed groove may be wide enough such that when cutting the sealed groove through the middle, the sealing on both sides of the cut stays intact.

FIG 6 shows a perspective view of another embodiment of a barrier foil segment 20 being cut from a continuous barrier foil 10. A cut 15' is made with a cutting means 54 along segment perimeter 15. The cutting takes place in direction 54d. The segment perimeter 15 and cut perimeter 15' extend parallel alongside a sealed groove 17 applied to the continuous barrier foil 10. When the cut 15' is complete, the foil segment 20 may be separated from the surrounding foil.

The shown embodiment may be suitable for dividing and cutting one or more foil segments 20 from a continuous barrier foil 10, provided as a sheet. It is noted that a single sealed groove may suffice to seal the entire segment. Optionally, there is provided a second sealed groove (not shown) on the other side of the segment perimeter 15, i.e. the segment perimeter being arranged between sealed grooves. This may be beneficial e.g. if the remainder 10' of the sheet also benefits from sealing, e.g. if a second foil segment is cut on a position adjacent a first foil segment.

Whereas the figure shows a rectangular foil segment 20, this may be any other desired shape such as a square, triangle, circle, oval, star, or any custom shape. The sealed groove 17 may generally follow a contour of the segment perimeter 15, e.g. being approximately parallel to the segment perimeter 15.

FIG 7 shows steps of an embodiment for dividing a foil segment 20 from a continuous barrier foil 10 using a laser 80.

The continuous barrier foil 10 comprises a continuous layered structure comprising an organic layer 12 sandwiched between barrier layers 11 and 13. In the shown embodiment, the continuous barrier foil 10 further comprises a substrate 14 and a support layer 25.

In step (B), the laser 80 partially cuts through the continuous barrier foil 10 forming an elongated groove 16 into the continuous barrier foil 10. The elongated groove 16 extends from one face 10a of the continuous barrier foil 10 all the way through at least the organic layer 12. In this embodiment the sealed groove 17 extends through the first of the barrier layers 11 and the organic layer 12 and ends at the second of the barrier layers 13 between the organic layer 12 and the support layer 25.

In an advantageous embodiment, the support layer 25 and the second of the barrier layers 13 have a lower extinction coefficient than the organic layer (e.g. a factor of two, preferably a factor of ten or more) in a wavelength range of the laser 80. A typical laser used for these tasks, e.g. an excimer laser, may have a wavelength in a range between 150 and 400 nm. Alternatively, a CO₂ laser typically has a wavelength around 10 µm, e.g. 9.4 or 10.6 µm. Without being bound to theory it is presumed that due to the lower extinction coefficient, less energy of the laser may be absorbed in the second barrier layer 13 and the support layer 25 e.g. per unit of distance traveled by the laser beam in these layers. In this way ablation of these layers 13 and 25 may be prevented or delayed. The ablation process may be better controlled to stop at the second barrier layer 13 thus not breaking this second barrier layer 13. By not breaking the second barrier layer 13 the sealing of the organic layer 12 may be improved.

In an embodiment, the extinction coefficient of the support layer 25 and the support layer thickness are chosen in relation to a laser light wavelength and intensity such that the extinction coefficient is low enough so as not to ablate the support layer 25, while the extinction coefficient and the support layer thickness are high enough to attenuate the laser light passing through the support layer 25 so as to prevent ablation of the underlying substrate 14.

In one example the substrate 14 comprises a PEN foil of 200 µm thickness. A layer of 10 µm Poly Methyl Methacrylate (PMMA) is deposited onto the substrate forming the support layer 25. The PMMA may form a smooth surface for the subsequent deposition of a 100 nm SiN layer forming a barrier layer 13. Onto the barrier layer 13, an organic layer 12 is deposited comprising a UV curable acrylate. The organic layer 12 may be used as a planarization layer for depositing another 100 nm barrier layer 11 of SiN. A KrF excimer laser, operating at a wavelength of 248 nanometers (nm) may be used for ablating the organic layer 12 whilst leaving the barrier layer 13 and support layer 25 intact.

Alternatively or in addition, the second barrier layer 13 and/or the support layer may be adapted to have an increased reflectivity for light of the laser. In this way the ablation of the second barrier layer 13 may also be prevented or delayed. Also, the support layer 25 may be reflective while the second barrier layer 13 is transmissive for light of the laser. In this way also ablation of the second barrier layer 13 may be prevented or delayed.

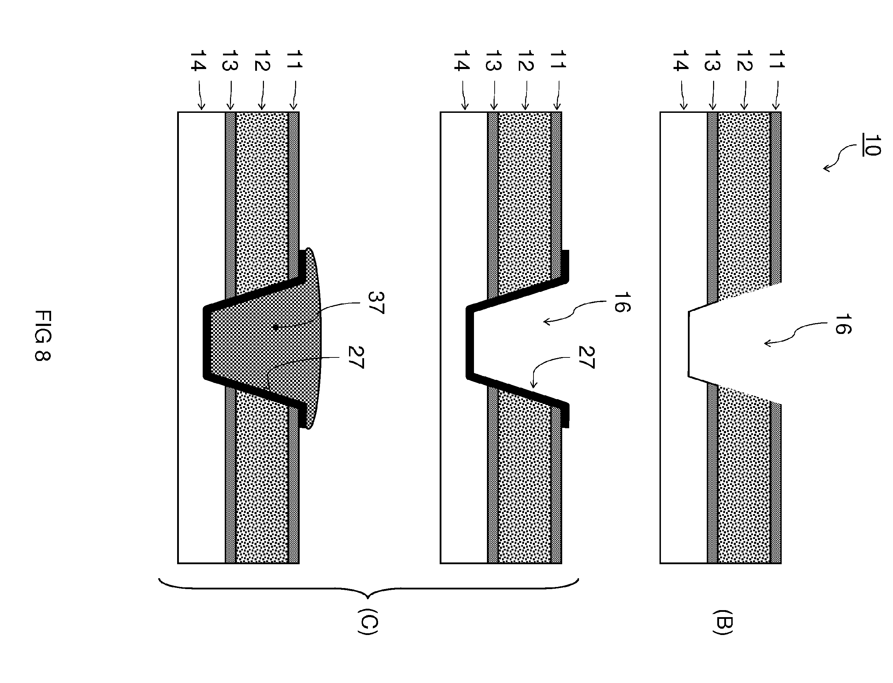

With continued reference to FIG 7, in step (C) a sealing material 17m is deposited into the elongated groove 16 thus forming a sealed groove 17. In the embodiment shown, the sealing material 17m is delivered by a Laser-Induced Forward Transfer (LIFT) process. The LIFT process comprises delivering laser pulses 82 from the laser 80 onto a donor substrate 97. The laser pulses 82 may cause drops 17d of the material 17m to be released, e.g. by shockwave and/or ablation, from the donor substrate 91 traveling in the direction of the groove 16 to be sealed. The donor substrate 97 may e.g. comprise a thin foil comprising the sealing material. The donor substrate 97 may be refreshed between laser shots, e.g. by translating the donor substrate in direction 91. Advantageously, the same laser 80 may be used for digging the groove 16 and for depositing the sealing material 17m. As explained with reference to FIG 2, it may be advantageous to provide a sealed groove comprising a mushroom shaped top. Alternatively or in addition to LIFT also other processes may be used for sealing the groove. E.g. LIFT may be used for forming a seed layer in the groove. A subsequent electroplating process e.g. shown in FIG 8 may be used to further seal the groove.

Optionally, during or after step (C), the sealing material 17m deposited into the groove 16 may be sintered. This may improve cohesion between the drops 17d that are deposited into the groove 16 and/or a wetting of the sealing material 17m onto the walls of the groove 16. Preferably, the sintering is applied by the same laser 80. Alternatively, the sintering is provided by another laser and/or by other means, e.g. thermally, UV, and/or microwave radiation.

With continued reference to FIG 7, in step (D) laser 80 is used for cutting through the continuous barrier foil 10 along the predefined segment perimeter, parallel to and distanced from the sealed groove 17. This may result in separating sealed barrier foil segment 20 from the remainder 10' of the continuous barrier foil. The sealed groove 17 and the barrier layers 11 and 13 are arranged for enclosing organic material 12m in at least part of the organic layer 12 and adapted for preventing, in use, external moisture and/or oxygen from reaching the organic material 12m when the barrier foil segment 20 is cut from the continuous barrier foil 10 along the pre-defined segment perimeter 15 through the continuous barrier foil 10.

In an advantageous embodiment, the same laser 80 is used for steps (B), (C), and (D). In a further embodiment, the laser 80 may be kept stationary between steps. After digging the groove in step (B) the donor substrate 97 may be provided between the barrier foil and the laser 80 for the LIFT process of step (C). With the laser 80 still targeting the same position on the barrier foil, the drops 17d may travel without further adjustment in the direction of the groove 16. After step (C), the donor substrate 97 may be removed or a hole may be burnt through the donor substrate 97. The barrier foil may be moved, e.g. in direction 61 and the same laser may be used for cutting the foil. Laser settings such as beam intensity or wavelength may optionally be altered between steps.

Alternatively, different lasers may be used for the different steps. The laser beams 81, 82, and 83 may thus be the same or modified between steps.

In a preferred embodiment, a laser beam 81 is used having a higher intensity in the center of the beam profile than at the edges, e.g. a Gaussian beam profile. Advantageously, when digging the groove 16 in step (B), this may result in faster ablation in the center of the beam than at the edges. This in turn may lead to a cone shaped groove 16 being tapered inward as viewed from the face 10a. This may have advantages for a subsequent sealing process wherein material is deposited into the groove. In particular, when depositing from the top face 10a into the groove 16, the material may be deposited onto the sides of the groove, i.e. onto the organic layer. This may improve a wetting (adherence, sticking) of the sealing material onto the organic and other layers. This may improve sealing quality. This idea is further illustrated in FIG 12. In general, a suitable sealant material has a high wettability and adhesion with the device stack, e.g. the organic layer and the barrier layers.

FIG 8 shows an embodiment for sealing a groove 16. In step (B) a groove 16 is formed in the continuous barrier foil 10 extending from a face of the foil at least through the organic layer 12 to be sealed. In this case the groove extends through both barrier layers 11 and 13 as well as partly into an underlying substrate 14. The step (C) of filling the groove comprises applying a seed layer 27 in the groove 16 and sealing the groove further with material 37.

The seed layer 27 may e.g. be formed using LIFT or any other suitable process such as Chemical Vapor Deposition (CVD). The further sealing material 37 may be grown onto the seed layer 27 e.g. by electroplating. A suitable electroplating material may e.g. comprise an ionic liquid. Preferably, the electroplating material does not comprise water as this may deteriorate a moisture sensitive organic layer.

Alternatively, the additional sealing material 37 may be provided by the same method as used in applying the seed layer, e.g. LIFT, CVD, etc. Preferably, the additional sealing material 37 is applied in a plurality of layer deposition steps, e.g. thirty layers. This may lower material stresses in the seal.

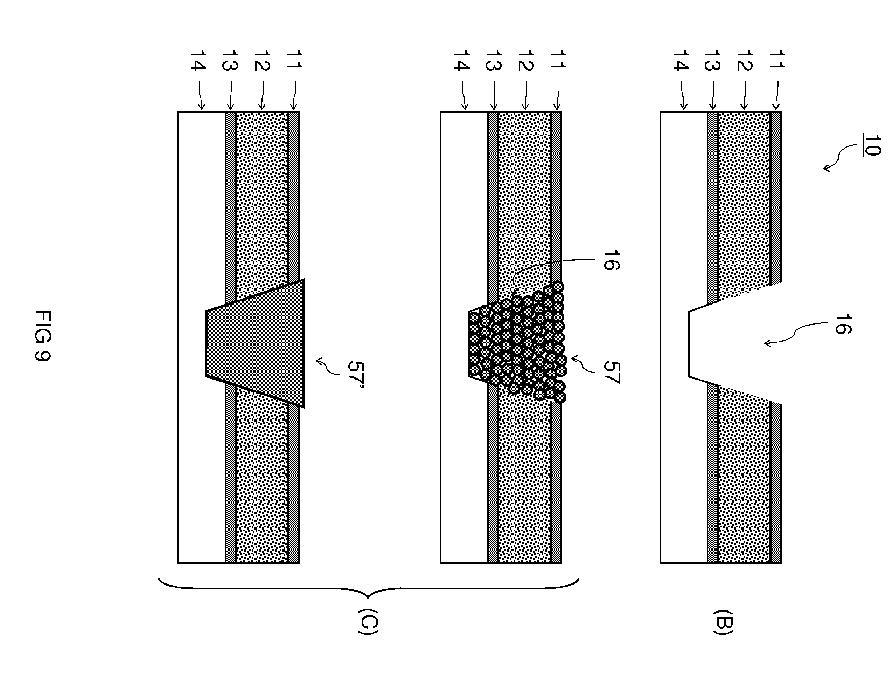

FIG 9 shows another embodiment for sealing a groove 16. The method comprises in step (C), filling the groove 16 with an inorganic powder 57 and at the same time or subsequently sintering the powder 57 to form a sealed groove comprising sintered material 57. The powder may e.g. comprise particles of SiO₂, TiO₂, or any other suitable material. Instead of a powder, also a liquid may be used, e.g. comprising nano particles, e.g. silver ink. Instead of filling the entire groove with powder or liquid and sintering all material, the sintering process may also be applied in layers to relieve stresses in the seal. Sintering may be performed using a laser. Alternatively or in addition, the powder or liquid may be cured thermally and/or by (UV) radiation. Also the powder may be sintered using microwave radiation.

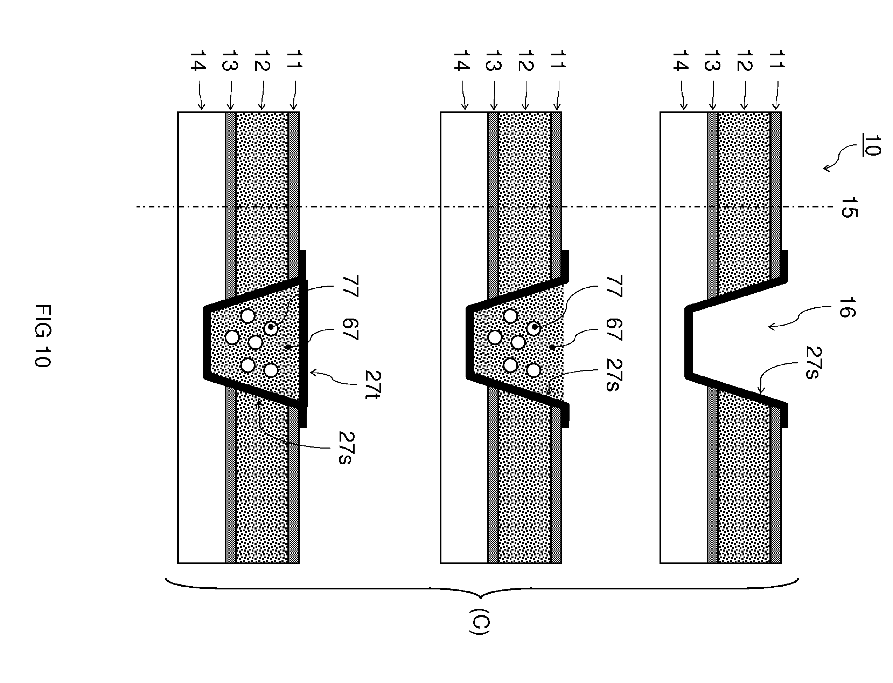

FIG 10 shows another embodiment for sealing a groove 16. In this approach, a stack of inorganic-organic-inorganic materials is envisaged as a sealant in the groove. As illustrated, in the groove, first an inorganic film 27s is deposited, followed by the organic filler 67 (e.g. OCP) with optional moisture getter particles 77 and then another inorganic layer 27t. A planarization layer could be optionally used. In this embodiment, the segment perimeter 15 is preferably distanced from the groove 16 so as not to cut the sealed groove. Suitable material for the inorganic layers 27s and 27t may include Al₂O₃, SiO₂ or SiN. Also metal layers may be used if these do not lead to unwanted short-circuiting. It is to be appreciated that the same material may be used for the barrier layers 11, 13, 27s, and 27t. Also the same material may be used for organic layer 12 and for the organic filler 67.

Suitable moisture getters may include zeolites, calcium-based moisture getters or any other hygroscopic compound.

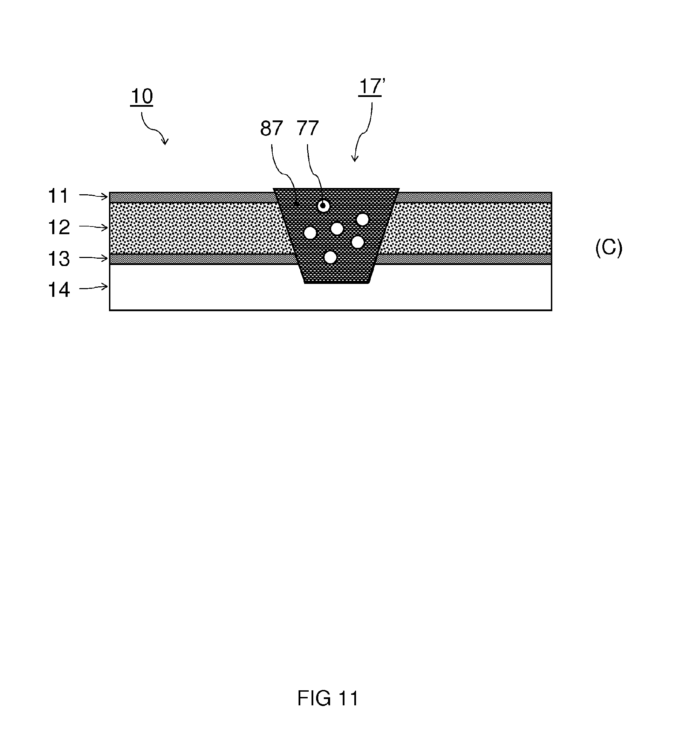

FIG 11 shows an embodiment of a sealed groove 17'. In this embodiment the groove is filled with a mixture 87 of organic and inorganic components, in which the amount of inorganic components is preferably very high in order to have a low diffusion coefficient of the mixture for moisture. Optionally, the inorganic component may comprise a moisture getter 77. The mixture may be sintered or cured. The inorganic particles such as Al₂O₃, TiO₂, SiO₂ may be embedded in an organic matrix, e.g. comprising a polyurethane or an acrylate. The organic matrix may aid in wetting or adhering the sealing material to the groove. Also it may allow a degree of plastic deformation.

FIG 12 shows another embodiment of a sealed groove 17. In this embodiment a sealing material 17m is deposited into the groove thus forming a sealed groove 17 comprising a single layer of sealing material 17m. In some embodiments, a single layer may be sufficient to protect the organic layer 12 from environmental influences. Accordingly, the groove need not be completely filled with the sealing material 17m. On the other hand completely filling the groove with sealing material may improve its sealing properties.

In a preferred embodiment, a groove has an oblique angle with respect to the surface of the substrate, i.e. the angle α between a side wall of the groove and the substrate surface is less than 90 degrees, preferably less than 80 degrees, e.g. in a range between 50 - 80 degrees. The smaller angle α may be beneficial e.g. when a groove such as shown is filled by projecting sealing material from the top into the groove. This may particularly beneficial for an embodiment wherein the groove is not completely filled, e.g. to sufficiently cover the side walls. Accordingly the sealed groove may comprise an inverted frustro-conical shape.

FIG 13 shows an OLED or OPV device stack 30 that may be considered as a barrier foil segment as described above. In particular, sealed grooves 17a and 17b may extend from a face of the device stack 30 through the organic layers at least until the bottom organic layer. The device stack 30 may be produced according to the methods described above. The device stack 30 comprises an electro-optical layer 31. The layered structures 20a and 20b are arranged to enclose the electro-optical layer 31 for preventing external moisture and/or oxygen 19 from reaching the electro-optical layer 31.

Preferably, a sealing material used for filling a groove through the device stack 30 does not comprise conductive material, e.g. metal. In this way short-circuiting of the device stack may be prevented.

In an embodiment, the device stack 30 may be produced in a continuous process by depositing the electro-optical layer 31 onto the bottom barrier structure 20a. The top barrier structure 20b may be manufactured separately and adhered with adhesive layer 28 on top of the electro-optical layer 31. Alternatively, the top barrier structure 20b may be deposited on top of the electro-optical layer 31 in a continuous deposition process.

Alternatively to the shown embodiment, a device stack 30 may also be produced by using two sealed barrier foil segments, manufactured as described above, for enclosing moisture and/or oxygen sensitive layers or components therein between.

In general the organic layer may comprise multiple organic layers that may optionally be separated by inorganic layers. Sealing the organic layers may thus comprise cutting a groove through all organic layers and sealing the groove.

In some device stacks it may be preferred that at least one of the barrier layers enclosing the organic layer be transparent to light, e.g. in an OLED or OPC stack. The other barrier layer may e.g. comprise a metal layer that need not be transparent.

While example systems were shown for providing a foil, digging grooves in a foil, sealing the grooves, and/or cutting a foil, also alternative systems and means may be used for achieving similar results. Whereas in the discussion, reference is made to a foil, the same methods and systems may be applicable to other structures, e.g. rigid substrates and layers. Optical components such as lasers, mirrors, lenses, etc may be combined or split up into one or more alternative optical components having similar effect. Similarly electrical components such as controllers and processors may be split into separate and/or dedicated components or be comprised in integrated circuitry.

The various elements of the embodiments as discussed and shown offer certain advantages, such as sealing a barrier foil. Of course, it is to be appreciated that any one of the above embodiments or processes may be combined with one or more other embodiments or processes to provide even further improvements in finding and matching designs and advantages. It is appreciated that this invention offers particular advantages to the prevention of moisture and/or oxygen from reaching an organic layer, and in general can be applied for any application wherein layers or components are to be sealed from external influences, e.g. other gasses. The disclosed methods may also be advantageously applied for sealing components of non-organic materials, e.g. a Copper indium gallium (di)selenide (CIGS) based solar cell. Instead of a barrier foil, the present disclosure may also find application in sealing other types of layered structures. Alternative or in addition to providing protection against environmental influences, the sealing may also be arranged for other functions, e.g. for electrical insulation, thermal insulation, etcetera. Steps need not necessarily be executed in the order as presented, e.g. the continuous barrier foil may be cut into foil segments prior to or during digging and/or sealing the grooves while resulting in similar advantages.

Finally, the above-discussion is intended to be merely illustrative of the present system and should not be construed as limiting the appended claims to any particular embodiment or group of embodiments. Thus, while the present system has been described in particular detail with reference to specific exemplary embodiments thereof, it should also be appreciated that numerous modifications and alternative embodiments may be devised by those having ordinary skill in the art without departing from the scope of the present systems and methods as set forth in the claims that follow. The specification and drawings are accordingly to be regarded in an illustrative manner and are not intended to limit the scope of the appended claims.

In interpreting the appended claims, it should be understood that the word "comprising" does not exclude the presence of other elements or acts than those listed in a given claim; the word "a" or "an" preceding an element does not exclude the presence of a plurality of such elements; any reference signs in the claims do not limit their scope; several "means" may be represented by the same or different item(s) or implemented structure or function; any of the disclosed devices or portions thereof may be combined together or separated into further portions unless specifically stated otherwise. The mere fact that certain measures are recited in mutually different claims does not indicate that a combination of these measures cannot be used to advantage.

## Claims

1. Method for dividing a barrier foil segment (20) from a continuous barrier foil (10), the continuous barrier foil (10) comprising a continuous layered structure comprising an organic layer (12) sandwiched between barrier layers (11, 13) the method comprising
(A) providing the continuous barrier foil (10), the continuous barrier foil (10) comprising a continuous layered structure comprising an organic layer (12) sandwiched between barrier layers (11, 13);
(B) partially cutting through the continuous barrier foil (10) forming an elongated groove (16) into the continuous barrier foil (10), the elongated groove (16) extending alongside a predefined segment perimeter (15) on the continuous barrier foil (10), the elongated groove (16) extending from one face (10a) of the continuous barrier foil (10) all the way through at least the organic layer (12); and
(C) depositing a sealing material (17m) into the elongated groove (16) thus forming a sealed groove (17) parallel to the predefined segment perimeter (15), the sealed groove (17) and the barrier layers (11, 13) arranged for enclosing organic material (12m) in at least part of the organic layer (12) and adapted for preventing, in use, external moisture and/or oxygen (19) from reaching the organic material (12m) when the barrier foil segment (20) is cut from the continuous barrier foil (10) along the pre-defined segment perimeter (15) through the continuous barrier foil (10).

2. Method according to claim 1, further comprising
(D) cutting through the continuous barrier foil (10) along the predefined segment perimeter (15).

3. Method according to any of the previous claims, wherein the predefined segment perimeter (15) is arranged at a distance (L) from the sealed groove (17), between the sealed groove (17) and a remnant (10') of the continuous barrier foil (10) from which the barrier foil segment (20) is to be cut.

4. Method according to any of the previous claims, wherein the sealed groove (17) forms a first sealed groove (17a), the method further comprising providing a second sealed groove (17b) extending alongside, and distanced from the first sealed groove (17a) wherein the predefined segment perimeter (15) is arranged between the first and second sealed grooves (17a, 17b).

5. Method according to any of the previous claims, wherein the partially cutting (B) the continuous barrier foil (10) is performed by irradiation of the continuous barrier foil (10) with a laser (80) tuned in wavelength, intensity, and timing for ablating the organic layer (12) while leaving at least part (13, 25) of the continuous barrier foil (10) in a path (81) of the laser (80) intact.

6. Method according to claim 5, wherein the continuous barrier foil (10) subsequently comprises
○ a first of the barrier layers (11) at a side of said one face (10a),
○ the organic layer (12),
○ a second of the barrier layers (13), and
○ a support layer (25), wherein
- the support layer (25) and the second of the barrier layers (13) have an at least two times lower extinction coefficient at the wavelength of the laser than the organic layer (12); and wherein
- the partially cutting (B) the continuous barrier foil (10) comprises applying the irradiation at said one face (10a), therewith cutting through the organic layer (12) and stopping at the second of the barrier layers (13) between the organic layer (12) and the support layer (25).

7. Method according to any of the previous claims, wherein the sealing (C) the elongated groove (16) comprises electroplating an ionic liquid in the elongated groove (16).

8. Method according to any of the previous claims, wherein the sealing (C) the elongated groove (16) comprises filling the elongated groove (16) with an inorganic powder and sintering the powder to form the sealed groove (17).

9. System (100) arranged for dividing a barrier foil segment (20) from a continuous barrier foil (10), the continuous barrier foil (10) comprising a continuous layered structure comprising an organic layer (12) sandwiched between barrier layers (11, 13), the system comprising a foil providing means (50, 60), a groove forming means (52), a groove sealing means (53), and a controller (70), the controller (70) arranged for
- controlling the foil providing means (50, 60) for providing the continuous barrier foil (10), the continuous barrier foil (10) comprising a continuous layered structure comprising an organic layer (12) sandwiched between barrier layers (11, 13);
- controlling the groove forming means (52) for partially cutting through the continuous barrier foil (10) forming an elongated groove (16) into the continuous barrier foil (10), the elongated groove (16) extending alongside a predefined segment perimeter (15) on the continuous barrier foil (10), the elongated groove (16) extending from one face (10a) of the continuous barrier foil (10) all the way through at least the organic layer (12); and
- controlling the groove sealing means (53) for depositing a sealing material (17m) into the elongated groove (16) thus forming a sealed groove (17) parallel to the segment perimeter (15), the sealed groove (17) and the barrier layers (11, 13) arranged for enclosing organic material (12m) in at least part of the organic layer (12) and adapted for preventing, in use, external moisture and/or oxygen (19) from reaching the organic material (12m) when the barrier foil segment (20) is cut from the continuous barrier foil (10) along the pre-defined segment perimeter (15) through the continuous barrier foil (10).

10. System (100) according to claim 9, further comprising a foil cutting means (54), wherein the controller (70) is further arranged for
- controlling the foil cutting means (54) for cutting through the continuous barrier foil (10) along the segment perimeter (15).

11. System (100) according to claims 9 or 10, wherein the foil providing means comprises a foil supply (50) on a roll and a foil transport system (60).

12. Barrier foil segment (20) comprising a layered structure comprising an organic layer (12) sandwiched between barrier layers (11, 13); the barrier foil segment (20) comprising a sealed groove (17) alongside a perimeter of the barrier foil segment (20), the sealed groove (17) formed by an elongated groove (16) extending partially through the barrier foil segment (20) from a face (20a) of the barrier foil segment (20) all the way through at least the organic layer (12); the elongated groove (16) filled with a sealing material (17m); the sealed groove (17) and the barrier layers (11, 13) arranged for enclosing organic material (12m) in at least part of the organic layer (12) and adapted for preventing, in use, external moisture and/or oxygen (19) from reaching the organic material (12m).

13. Barrier foil segment according to any of the previous claims, wherein the sealed groove (17) comprises a moisture getter (77).

14. Barrier foil segment according to any of the previous claims, wherein the layered structure subsequently comprises
○ a first of the barrier layers (11)
○ the organic layer (12),
○ a second of the barrier layers (13), and
○ a support layer (25), wherein
the support layer (25) and the second of the barrier layers (13) have an at least two times lower extinction coefficient than the organic layer (12) in at least part of a wavelength range between 150 and 400 nm or between 9.4 and 10.6 micrometers; and
- the sealed groove (17) extends through the first of the barrier layers (11) and the organic layer (12) and ends at the second of the barrier layers (13) between the organic layer (12) and the support layer (25).

15. OLED or OPV device stack (30) comprising
- the barrier foil segment (20) according to any of the previous claims, and
- an electro-optical layer (31); wherein the barrier foil segment (20) is arranged to enclose the electro-optical layer (31) for preventing external moisture and/or oxygen (19) from reaching the electro-optical layer (31).
